# EUROPEAN PATENT APPLICATION

(11) **EP 2 657 316 A1**
(43) Date of publication of application: **30.10.2013**
(21) Application number: 10861024.7
(22) Date of filing: 24.12.2010
(51) Int. Cl.: C09K 11/54, H01L 31/02

(54) **ELECTRICALLY CONDUCTIVE FILM, PERPARATION METHOD AND APPLICATION THEREFOR**

(71) Applicant: Ocean's King Lighting Science&Technology Co., Ltd., Guangdong 518054 (CN)
(72) Inventor: ZHOU, Mingjie, Shenzhen, Guangdong 518054 (CN); WANG, Ping, Shenzhen, Guangdong 518054 (CN); CHEN, Jixing, Shenzhen, Guangdong 518054 (CN); FENG, Xiaoming, Shenzhen, Guangdong 518054 (CN)
(74) Representative: Johnson, Richard Alan
(86) International application number: PCT/CN2010/080269
(87) International publication number: WO 2012/083562

(57) **Abstract**

An electrically conductive film is provided, which comprises a film formed of zinc oxide adulterated with alumina, silicon dioxide and magnesia. The transparence of the zinc oxide film is increased by means of magnesium ion in the adulterated magnesia widening the transparent window of the zinc oxide film, the conductivity is increased and thus the resistivity is reduced by means of adulterating with alumina and silicon dioxide, and the resistivity during working is stabilized by means of adulterating with alumina, silicon dioxide and magnesia. A method for manufacturing the electrically conductive film and an application therefor are also provided. The method has simple process, mild conditions, low cost and high productivity, which is suit for industrialized produce.

## Description

### FIELD OF THE INVENTION

The present invention relates to the field of semiconductor photoelectric materials technology, more particularly to an electrically conductive film, as well as preparation method and application thereof.

### BACKGROUND OF THE INVENTION

In the prior art, the electrically conductive film formed of zinc oxide is commonly electrically conductive film formed of zinc oxide which is doped with single element. There are many problems that exist in the preparation and applications. Taking electrically conductive film formed of zinc oxide which is doped with single aluminum (Al∼doped ZnO, abbr. AZO) as an example, it is hard to prepare thin film having low resistance, and this is one of the reasons why AZO thin film haven't been put into production yet. Moreover, when AZO is being used, oxygen absorption on the boundary between surface and grains occurs, leading to a decline of conductivity performance, and unstable resistivity.

### SUMMARY OF THE INVENTION

In view of this, the present invention provides an electrically conductive film solving technical problems that existing electrically conductive film has high resistivity and instability. The present invention further provides a method for preparing electrically conductive film. The present invention also provides applications of the above electrically conductive film in electroluminescent devices, solar cells or field effect transistors.

An electrically conductive film comprising a film formed of zinc oxide, the film formed of zinc oxide is doped with alumina, silicon dioxide and magnesia.

A method for preparing electrically conductive film provided in the present invention, comprising:

mixing zinc oxide with magnesia, alumina and silicon dioxide, stirring to produce mixture;

mass percentages of zinc oxide, alumina, silicon dioxide and magnesia in the mixture are as follows: zinc oxide 70∼94%, alumina 0.5∼3%, silicon dioxide 0.5∼3%, magnesia 5∼25%, sintering said mixture to form magnetron sputtering target materials;

magnetron sputtering to form film using said magnetron sputtering target materials, obtaining electrically conductive film.

Electrically conductive film of the embodiment of the present invention comprising a film formed of zinc oxide doped with magnesia can greatly increase the transmittance of the film formed of zinc oxide by using magnesium to widen its transparent window; the conductivity of the film formed of zinc oxide is greatly increased and thus the resistivity is reduced by doping with alumina and silicon dioxide, and the resistivity during working is kept stable by doping with the above three matters. The method of the present invention has simple process, mild conditions, low cost and high productivity, which is suit for industrialized production.

### BRIEF DESCRIPTION OF THE DRAWINGS

Fig. 1 is transmission spectrum of electrically conductive film of the embodiment of the present invention;

Fig. 2 is XRD pattern of electrically conductive film of the embodiment of the present invention;

Fig. 3 is curve showing changes of resistivity of electrically conductive film of the embodiment of the present invention after being used for 48 hours at various temperatures.

### DETAILED DESCRIPTION OF ILLUSTRATED EMBODIMENTS

Further description of the present invention will be illustrated, which combined with embodiments in the drawings, in order to make the purpose, the technical solution and the advantages clearer. While the present invention has been described with reference to particular embodiments, it will be understood that the embodiments are illustrative and that the invention scope is not so limited.

The embodiment of the present invention provides an electrically conductive film comprising a film formed of zinc oxide, the film formed of zinc oxide is doped with alumina, silicon dioxide and magnesia.

Specifically, electrically conductive film of the embodiment of the present invention is mainly made up of zinc oxide, furthermore, silicon dioxide, magnesia and alumina dope the film formed of zinc oxide, the zinc oxide, silicon dioxide, magnesia and alumina dope evenly, thus making transmittance of the electrically conductive film to avoid the adverse effect caused by accumulation of the dopants (magnesia, alumina and silicon dioxide).

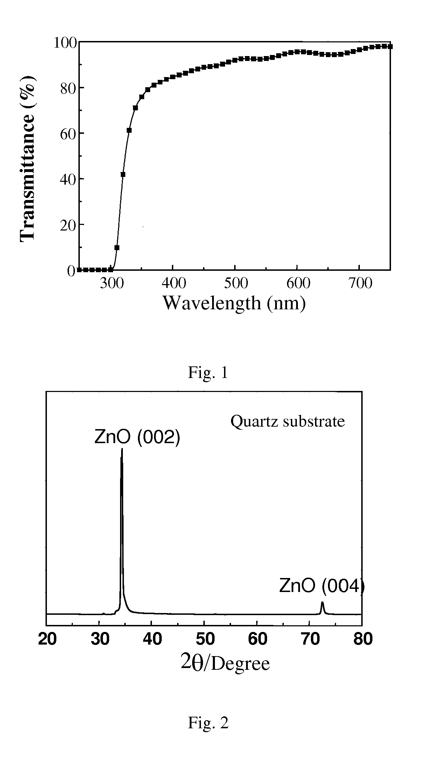

Referring to Fig. 1, Fig. 1 shows transmission spectrum of electrically conductive film of the embodiment of the present invention. It can be seen from the Fig. 1 that the electrically conductive film has a transmittance in the range of 80%∼99% at wavelength between 500 nm and 700 nm, the electrically conductive film has excellent light transmitting performance.

Referring to Fig. 2, Fig. 2 depicts XRD pattern of electrically conductive film of the embodiment of the present invention. It can be seen from the Fig. 2 that only zinc oxide (002) and (004) show peak values, indicating that silicon dioxide, magnesia and alumina of the electrically conductive film of the embodiment of the present invention have entered into crystal lattice of zinc oxide.

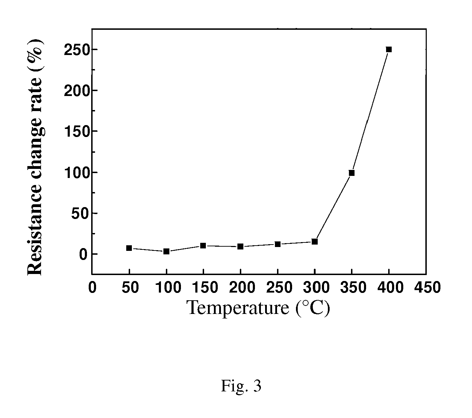

Referring to Fig. 3, four-point probes method is used to measure resistivity of the samples see Tab. 1, resistivity is in the range of 5×10⁻³Ω·cm∼7.6×10⁻⁴Ω·cm. Fig. 3 depicts a curve showing changes of resistivity of electrically conductive film of the embodiment of the present invention after being used for 48 hours at various temperatures. It can be seen from the Fig. 3 that resistivity changes within a narrow range when using the electrically conductive film of the embodiment of the present invention, and resistivity changes between 0% and 15% when using for 0∼48 hours at temperature ranged from 50°C to 300°C.

Electrically conductive film of the embodiment of the present invention comprising a film formed of zinc oxide doped with magnesia can greatly increase the transmittance of the film formed of zinc oxide by using magnesium to widen its transparent window; by doping with alumina and silicon dioxide, because alumina contains trivalent aluminum ions, silicon dioxide contains tetravalent silicon ion, thus forming electron carriers in the film formed of zinc oxide, so that the conductivity of the film formed of zinc oxide is greatly increased and the resistivity is reduced; furthermore, multiple elements dope the film formed of zinc oxide, making the resistivity of the electrically conductive film of the embodiment of the present invention to keep stable during working process.

mass percentages of such four matters in electrically conductive film are as follows:

zinc oxide 70∼94%

alumina 0.5∼3%

silicon dioxide 0.5∼3%

magnesia 5∼25%.

Preferably, mass percentage of zinc oxide is in the range of 75∼90%, mass percentage of alumina is in the range of 1∼2%; mass percentage of silicon dioxide is in the range of 1∼1.5%; mass percentage of magnesia is in the range of 10∼20%.

The embodiment of the present invention further provides a method for preparing electrically conductive film, comprising:

S01, preparing magnetron sputtering target materials

mixing zinc oxide with magnesia, alumina and silicon dioxide, stirring to produce mixture;

mass percentages of zinc oxide, alumina, silicon dioxide and magnesia in the mixture are as follows: zinc oxide 70∼94%, alumina 0.5∼3%, silicon dioxide 0.5∼3%, magnesia 5∼25%, sintering the mixture to form magnetron sputtering target materials;

S02, magnetron sputtering to form film

magnetron sputtering to form film using said magnetron sputtering target materials, obtaining electrically conductive film.

Specifically, in step S01, zinc oxide is mixed with magnesia, alumina and silicon dioxide, then stirred thoroughly to make magnesia, alumina and silicon dioxide to evenly dope zinc oxide and form mixture. In the mixture, mass percentages of such four matters are as follows: zinc oxide 70∼94%, alumina 0.5∼3%, silicon dioxide 0.5∼3%, magnesia 5∼25%.

Preferably, mass percentage of zinc oxide is in the range of 75∼90%, mass percentage of alumina is in the range of 1∼2%; mass percentage of silicon dioxide is in the range of 1∼1.5%; mass percentage of magnesia is in the range of 10∼20%.

Specifically, when preparing magnetron sputtering target materials, the sintering temperature is in the range of 900∼1100°C, atmosphere is non-reducing atmosphere, such as inert atmosphere or air atmosphere. Sintering time is in the range of 1∼24 hours. After calcining at high temperature, alumina, silicon dioxide and magnesia dope into crystal lattice of zinc oxide and form sputtering target materials, the sputtering target materials is rounded target materials having diameter of 50 mm, thickness of 2mm; the inert atmosphere is helium atmosphere, argon atmosphere, neon atmosphere or nitrogen atmosphere.

In step S02, the magnetron sputtering target materials are firstly placed into chamber of magnetron sputtering device, substrate is taken and placed into the chamber of magnetron sputtering device, where is vacuumed to 1.0×10⁻³Pa∼1.0×10⁻⁵Pa by mechanical pump and molecular pump; then spacing between the substrate and sputtering target materials is adjusted to 50∼90 millimeters, and the temperature of substrate is regulated to 300∼800°C; electrically conductive film is obtained by sputtering for 1∼3 hours at the working pressure of 0.2∼1.5Pa and gas flow rate of 15∼25sccm.

Specifically, substrate used in the step of magnetron sputtering is quartz glass, the quartz glass is ultrasonic cleaned with acetone, absolute ethanol and deionized water, then blow-dried with high purity nitrogen; the used magnetron sputtering device is not limited, can be various models of magnetron sputtering devices; the purity of used zinc oxide, magnesia, silicon dioxide and alumina is greater than mass percentage 99.9%.

Furthermore, magnetron sputtering device is vacuumed to a preferred degree of vacuum 6.0×10⁻⁴Pa; furthermore, spacing between the substrate and sputtering target materials is preferably 60 millimeters, the temperature of substrate is preferably 450°C, working pressure is preferably 1.0Pa and gas flow rate is preferably 20sccm. The gas supplied during the step of magnetron sputtering is inert gas, such as argon, helium, neon, etc. Setting up parameters as the above to ensure a faster deposition rate, and that zinc oxide, magnesia, silicon dioxide and alumina of electrically conductive film can dope evenly according to mass percentages in sputtering target materials.

The method of the present invention has simple process, mild conditions, low cost and high productivity, which is suit for industrialized produce.

The embodiment of the present invention further provides applications of the above electrically conductive film in electroluminescent devices, solar cells or field effect transistors.

Further description of the preparation method of the present invention will be illustrated below, which combined with embodiments.

Example 1

The components were mixed evenly as the following weight percentages, then calcined at 1000°C in the air atmosphere for 12 hours to form rounded ceramic sputtering target materials having a diameter of 50mm, a thickness of 2mm, which was subsequently placed into vacuum chamber of magnetron sputtering device, according to the mass percentages:

ZnO 77.5%, Al₂O₃ 1.5%, SiO₂ 1% and MgO 20%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 60mm. The chamber was vacuumed to 6.0×10⁻⁴ Pa by mechanical pump and molecular pump. Argon flow rate was regulated to 20sccm, pressure was regulated to 1.0Pa, and the temperature of quartz glass was 450°C. Electrically conductive film was obtained after magnetron sputtering and depositing for 2 hours.

Tab. 1 shows that resistivity was 7.6×10⁻⁴Ω·cm.

Example 2

The components were mixed evenly as the following weight percentages, then calcined at 1100°C in the air atmosphere for 1 hour to form rounded ceramic sputtering target materials having a diameter of 50mm, a thickness of 2mm, which was subsequently placed into vacuum chamber of magnetron sputtering device, according to the mass percentages:

ZnO 90%, Al₂O₃ 2%, SiO₂ 1% and MgO 7%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 90mm. The chamber was vacuumed to 1.0×10⁻³Pa by mechanical pump and molecular pump. Argon flow rate was regulated to 25sccm, pressure was regulated to 1.5a, and the temperature of quartz glass was 800°C. Electrically conductive film was obtained after magnetron sputtering and depositing for 3 hours.

Tab. 1 shows that resistivity was 8.5×10⁻⁴Ω·cm.

Example 3

The components were mixed evenly as the following weight percentages, then calcined at 900°C in the air atmosphere for 24 hours to form rounded ceramic sputtering target materials having a diameter of 50mm, a thickness of 2mm, which was subsequently placed into vacuum chamber of magnetron sputtering device, according to the mass percentages:

ZnO 94%, Al₂O₃ 0.5%, SiO₂ 0.5% and MgO 5%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 50mm. The chamber was vacuumed to 6.0×10⁻⁴ Pa by mechanical pump and molecular pump. Argon flow rate was regulated to 15sccm, pressure was regulated to 0.2Pa, and the temperature of quartz glass was 300°C. Electrically conductive film was obtained after magnetron sputtering and depositing for 1 hour.

Tab. 1 shows that resistivity was 1.35×10⁻³Ω·cm.

Example 4

The components were mixed evenly as the following weight percentages, then calcined at 900°C in the air atmosphere for 12 hours to form rounded ceramic sputtering target materials having a diameter of 50mm, a thickness of 2mm, which was subsequently placed into vacuum chamber of magnetron sputtering device, according to the mass percentages:

ZnO 80%, Al₂O₃ 3%, SiO₂ 1% and MgO 16%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 50mm. The chamber was vacuumed to 6.0×10⁻⁴ Pa by mechanical pump and molecular pump. Argon flow rate was regulated to 15sccm, pressure was regulated to 0.2Pa, and the temperature of quartz glass was 300°C. Electrically conductive film was obtained after magnetron sputtering and depositing for 1 hour.

Tab. 1 shows that resistivity was 2.45×10⁻³Ω·cm.

Example 5

The components were mixed evenly as the following weight percentages, then calcined at 900°C in the air atmosphere for 20 hours to form rounded ceramic sputtering target materials having a diameter of 50mm, a thickness of 2mm, which was subsequently placed into vacuum chamber of magnetron sputtering device, according to the mass percentages:

ZnO 77.5%, Al₂O₃ 1.5%, SiO₂ 1% and MgO 20%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 65mm. The chamber was vacuumed to 7.0×10⁻⁴ Pa by mechanical pump and molecular pump. Argon flow rate was regulated to 18sccm, pressure was regulated to 1.3Pa, and the temperature of quartz glass was 400°C. Electrically conductive film was obtained after magnetron sputtering and depositing for 1.5 hours.

Tab. 1 shows that resistivity was 4.7×10⁻³Ω·cm.

Example 6

The components were mixed evenly as the following weight percentages, then calcined at 950°C in the air atmosphere for 16 hours to form rounded ceramic sputtering target materials having a diameter of 50mm, a thickness of 2mm, which was subsequently placed into vacuum chamber of magnetron sputtering device, according to the mass percentages:

ZnO 73%, Al₂O₃ 0.5%, SiO₂ 1.5% and MgO 25%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 90mm. The chamber was vacuumed to 6.0×10⁻⁴Pa by mechanical pump and molecular pump. Argon flow rate was regulated to 21sccm, pressure was regulated to 1.1Pa, and the temperature of quartz glass was 700°C. Electrically conductive film was obtained after magnetron sputtering and depositing for 1.5 hours.

Tab. 1 shows that resistivity was 2.7×10⁻³Ω·cm.

Example 7

The components were mixed evenly as the following weight percentages, then calcined at 950°C in the air atmosphere for 16 hours to form rounded ceramic sputtering target materials having a diameter of 50mm, a thickness of 2mm, which was subsequently placed into vacuum chamber of magnetron sputtering device, according to the mass percentages:

ZnO 70%, Al₂O₃ 2.5%, SiO₂ 2.5% and MgO 25%;

Quartz glass was ultrasonic cleaned with acetone, absolute ethanol and deionized water, then blow-dried with high purity nitrogen, placed into the above vacuum chamber of magnetron sputtering device;

Spacing between substrate and sputtering target materials was adjusted to 50mm. The chamber was vacuumed to 1.0×10⁻⁵Pa by mechanical pump and molecular pump. Argon flow rate was regulated to 21sccm, pressure was regulated to 1.1Pa, and the temperature of quartz glass was 700°C. Electrically conductive film was obtained after magnetron sputtering and depositing for 1.5 hours.

Tab. 1 shows that resistivity was 5×10⁻³Ω·cm.

Tab. 1 Resistivity of electrically conductive film of the embodiments

| Number | Example 1 | Example 2 | Example 3 | Example 4 | Example 5 | Example 6 | Example 7 |
|---|---|---|---|---|---|---|---|
| Resistivity | 0.76 | 0.85 | 1.35 | 2.45 | 4.7 | 2.7 | 5 |
| (10^{- 3}Ω·cm) | | | | | | | |

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Such alternate embodiments are considered to be encompassed within the spirit and scope of the present invention. Accordingly, the scope of the present invention is described by the appended claims and is supported by the foregoing description.

## Claims

1. An electrically conductive film comprising a film formed of zinc oxide, wherein said film formed of zinc oxide is doped with alumina, magnesia and silicon dioxide.

2. The electrically conductive film as claimed in claim 1, wherein mass percentages of said zinc oxide, alumina, magnesia and silicon dioxide are as follows: zinc oxide 70∼94%, alumina 0.5∼3%, silicon dioxide 0.5∼3%, magnesia 5∼25%.

3. The electrically conductive film as claimed in claim 2, wherein mass percentages of said alumina, silicon dioxide and magnesia are as follows: zinc oxide 75∼90%, alumina 1∼2%, silicon dioxide 1∼1.5%, magnesia 10∼20%.

4. The electrically conductive film as claimed in claim 3, wherein having a transmittance in the range of 80%∼99% at wavelength between 500 nm and 700 nm.

5. The electrically conductive film as claimed in claim 3, wherein resistivity of said electrically conductive film is in the range of 5×10⁻³Ω·cm∼7.6×10⁻⁴Ω·cm.

6. A method for preparing electrically conductive film, comprising:
mixing zinc oxide with magnesia, alumina and silicon dioxide, stirring to produce mixture;
mass percentages of zinc oxide, alumina, silicon dioxide and magnesia in said mixture are as follows: zinc oxide 70∼94%, alumina 0.5∼3%, silicon dioxide 0.5∼3%, magnesia 5∼25%, sintering said mixture to form magnetron sputtering target materials; magnetron sputtering to form film using said magnetron sputtering target materials, obtaining electrically conductive film.

7. The method for preparing electrically conductive film as claimed in claim 6, wherein in said step of forming sputtering target materials by sintering, sintering temperature is in the range of 900∼1100°C, atmosphere is inert atmosphere or air atmosphere, time is in the range of 1∼24 hours.

8. The method for preparing electrically conductive film as claimed in claim 6, wherein said inert atmosphere is helium atmosphere, argon atmosphere, neon atmosphere or nitrogen atmosphere.

9. The method for preparing electrically conductive film as claimed in claim 6, wherein said magnetron sputtering involves placing said magnetron sputtering target materials into chamber of magnetron sputtering device, taking substrate and placing into said chamber of magnetron sputtering device where the degree of vacuum is in the range of 1.0×10⁻³Pa∼1.0×10⁻⁵Pa, adjusting the spacing between said substrate and sputtering target materials to 50∼90 millimeters, regulating the temperature of substrate to 300∼800°C, sputtering for 1∼3 hours at the working pressure of 0.2∼1.5Pa and gas flow rate of 15∼25sccm.

10. Applications of the electrically conductive film as claimed in any one of the claims from 1 to 5 in solar cells, electroluminescent devices or field effect transistors.
